# DEMANDE DE BREVET EUROPEEN

(11) **EP 4 838 229 A1**
(43) Date de publication de la demande: **11.11.2026**
(21) Numéro de dépôt: 26174808.1
(22) Date de dépôt: 27.04.2026
(51) Int. Cl.: G01R 11/04, G01R 22/06

(54) **PROCÉDÉ D'INSTALLATION D'UN BOÎTIER DE COMPTEUR D'ÉNERGIE ÉLECTRIQUE, COMPTEUR D'ÉNERGIE ÉLECTRIQUE ET BRIDE POUR UN TEL PROCÉDÉ**

(30) Priorité: 07.05.2025 FR 2504889
(71) Demandeur: SAGEMCOM ENERGY & TELECOM SAS, 92270 Bois-Colombes (FR)
(72) Inventeur: TOUZ, Frédéric, 92270 Bois-Colombes (FR)
(74) Mandataire: Novagraaf Technologies

(57) **Abrégé**

L'invention propose un procédé d'installation sur une paroi (100) d'un boîtier (12) d'un compteur (10) d'énergie par des moyens qui comportent, une vis (200) et une patte (60), appartenant à une bride (40), qui coopèrent pour maintenir la face arrière (14) du boîtier en appui plan contre la face avant (102) de la paroi (100), procédé qui comporte les étapes consistant à : incliner la face arrière (14) du boîtier (12) par rapport à la paroi (100) ; amener l'arête supérieure arrière (15) du boîtier adjacente à la paroi (100) ; déplacer le boîtier (12) vers le haut par rapport à la vis (200) jusqu'à une position d'installation (12) en faisant simultanément pivoter le boîtier (12) de manière à amener la face arrière (14) du boîtier (12) en appui plan contre la paroi verticale (100) ; et immobiliser verticalement le boîtier (12) dans sa position haute d'installation. L'invention propose aussi un compteur d'énergie et une bride d'installation pour la mise en œuvre du procédé.

## Description

### Domaine technique de l'invention

L'invention concerne le domaine des compteurs d'énergie, notamment mais non limitativement les compteurs d'énergie électrique.

L'invention concerne plus particulièrement un procédé d'installation, sur une paroi verticale, d'un boîtier de compteur d'énergie.

### Arrière-plan technique de l'invention

Parmi les compteurs d'énergie, on appelle compteur d'énergie électrique, ou compteur d'électricité, ou encore compteur électrique un organe électrique servant à mesurer la quantité d'énergie électrique consommée dans un lieu.

Un compteur d'énergie peut être installé à l'intérieur ou à l'extérieur du lieu ou local de consommation de l'énergie.

A cet effet, dans la zone dans laquelle le compteur est installé, il est nécessaire de disposer d'un environnement dimensionnel suffisant pour permettre d'y loger le compteur d'énergie et aussi pour permettre les opérations d'installation et de fixation du compteur d'énergie.

L'installation peut ainsi s'avérer particulièrement difficile, voire impossible, lorsque l'espace disponible, délimité par des obstacles environnants, correspond pratiquement à l'encombrement du boîtier du compteur d'énergie.

Ainsi, l'aire de la surface de paroi verticale disponible pour la fixation du boîtier n'excède alors quasiment pas l'aire de la surface dite de « placage hors-tout » du compteur, surface qui est définie par la hauteur et la largeur transversale du boîtier du compteur d'énergie.

Par installation, on entend ainsi les étapes permettant le positionnement et la fixation du boîtier du compteur d'énergie, sur une face verticale d'une paroi dans un espace ou volume disponible déterminé.

Selon une conception connue du boîtier d'un compteur d'énergie, et afin de faciliter l'ergonomie de l'installation et de la fixation, on vient plaquer la face arrière du boîtier contre la face avant de la paroi dans une position décalée vers le haut par rapport à sa position nominale d'installation, puis on le déplace verticalement vers le bas pour l'accrocher le long de la paroi par des moyens de positionnement et de fixation comportant une patte d'accrochage munie d'une boutonnière dans laquelle est reçue une vis installée sur la paroi.

Il est ainsi nécessaire de disposer d'une hauteur d'installation supérieure à la hauteur totale hors-tout du boîtier.

L'invention a notamment pour but de remédier à tout ou partie de ces inconvénients en permettant une installation et une fixation ergonomique dans un volume disponible réduit.

### Résumé de l'invention

L'invention propose un procédé d'installation sur une paroi verticale d'un boîtier d'un compteur d'énergie qui est délimité :
- par une face arrière apte à être maintenue en appui plan contre une face avant de la paroi verticale ;
- et par une face supérieure destinée à occuper une position verticale déterminée le long de la paroi verticale et qui, avec la face arrière du boîtier, détermine une arête supérieure arrière du boîtier,
par des moyens de positionnement et de fixation qui comportent, au niveau de la face supérieure du boîtier, une vis fixée sur la paroi verticale et une patte qui, lors de l'installation du boîtier sur la face avant de la paroi verticale, coopèrent pour maintenir la face arrière du boîtier en appui plan contre la face avant de la paroi verticale, procédé qui comporte les étapes successives consistant à :
-- E1) incliner la face arrière du boîtier par rapport à la paroi verticale ;
-- E2) amener l'arête supérieure arrière du boîtier adjacente à la face avant de la paroi verticale ;
-- E3) déplacer le boîtier vers le haut par rapport à la vis jusqu'à une position haute d'installation du boîtier en faisant simultanément pivoter le boîtier par rapport à la paroi verticale de manière à amener la face arrière du boîtier en appui plan contre la paroi verticale ;
-- E4) immobiliser verticalement le boîtier dans sa position haute d'installation par des moyens supplémentaires de fixation appartenant auxdits moyens de positionnement et de fixation.

Selon d'autres caractéristiques du procédé :
- il comporte une étape préalable E0) consistant, au moyen de la vis, à fixer ladite patte sur la face avant de la paroi verticale selon une position et une orientation lui permettant de pénétrer dans un logement complémentaire du boîtier ;
- il comporte une étape préalable E0) consistant à fixer la patte sur le boîtier selon une position et une orientation permettant à la vis de pénétrer dans une fente de la patte ;
- pour immobiliser verticalement le boîtier dans sa position haute d'installation, lesdits moyens de fixation comportent au moins une autre vis qui traverse axialement un trou du boîtier et qui est vissée dans la paroi verticale.

Pour la mise en œuvre du procédé, l'invention propose un compteur d'énergie qui comporte un boîtier :
- qui est délimité par une face arrière apte à être maintenue en appui plan contre une face avant d'une paroi verticale et par une face supérieure qui est destinée à occuper une position verticale déterminée le long de la paroi verticale et qui, avec la face arrière du boîtier, détermine une arête supérieure arrière du boîtier ;
- qui comporte un logement qui est ouvert dans sa face supérieure,

compteur qui porte une bride d'installation dont une patte, comportant une fente, qui est apte à être fixée par une vis sur la paroi verticale, qui détermine la position verticale du boîtier et qui maintient la face arrière du boîtier en appui plan contre la face avant de la paroi verticale,
compteur dans lequel :
   -- la bride d'installation comporte une embase pour sa fixation dans ledit logement ;
   -- la patte prolonge l'embase vers le haut ;
   -- la fente est ouverte vers le haut pour, lorsque le boîtier est déplacé vers le haut par rapport à la vis, permettre à la vis de pénétrer verticalement dans la fente.

Selon d'autres caractéristiques du compteur d'énergie :
- un tronçon d'extrémité libre supérieure de la patte est profilé en forme de rampe pour faciliter la pénétration de la vis dans la fente lorsque, au cours de son déplacement vers haut, la face arrière du boîtier est inclinée par rapport à la paroi verticale ;
- l'embase est fixée dans ledit logement par emboîtement élastique.

L'invention propose encore une bride d'installation sur une paroi verticale d'un compteur d'énergie par la mise en œuvre du procédé selon l'invention, caractérisée en ce que :
- elle comporte une embase apte à être fixée sur la paroi verticale par une vis et qui se prolonge, verticalement vers le bas, par une patte ;
- l'embase comporte une face arrière plane apte à être montée serrée, en appui plan sur la face avant de la paroi verticale, par la vis qui traverse axialement un trou de l'embase orthogonal au plan de sa face arrière ;
- la patte est décalée axialement vers l'avant par rapport au plan de la face arrière de l'embase, de manière à délimiter un jeu par rapport à la face avant de la paroi verticale.

Selon d'autres caractéristiques de la bride :
- l'extrémité libre inférieure de la patte est profilée en forme de rampe pour faciliter sa pénétration dans le logement lorsque, au cours du déplacement du boîtier vers haut, la face arrière du boîtier est inclinée par rapport à la paroi verticale.

L'invention propose encore une bride d'installation sur une paroi verticale d'un compteur d'énergie par la mise en œuvre du procédé selon l'invention, caractérisée en ce qu'elle comporte une embase, apte à être fixée dans un logement du boîtier du compteur, qui se prolonge verticalement vers le haut par une patte comportant une fente qui est ouverte vers le haut pour permettre à une vis de pénétrer verticalement dans la fente.

Selon une autre caractéristique, l'embase est apte à être fixée par emboîtement élastique dans ledit logement du boîtier du compteur.

### Brève description des figures

[Fig. 1A], [Fig. 1B], [Fig. 1C] - la figure 1A, la figure 1B et la figure 1C sont trois schémas permettant d'illustrer le problème technique selon l'état de la technique ;
[Fig. 2] - la figure 2 est une vue en perspective de trois-quarts arrière et partiellement éclatée, du boîtier d'un compteur d'électricité ;
[Fig. 3] - la figure 3 est une vue de détail en perspective et à plus grande échelle de la partie supérieure du boîtier illustré à la figure 2 ;
[Fig. 4] - la figure 4 est une vue en perspective de trois-quarts avant et partiellement éclatée, du boîtier de compteur d'électricité de la figure 2 associé à une paroi verticale et à un premier exemple de réalisation des moyens selon l'invention pour la fixation du boîtier sur cette paroi ;
[Fig.5] - la figure 5 est une à plus grande échelle d'un détail de la partie supérieure de l'ensemble illustré à la figure 4 ;
[Fig. 6] - la figure 6 est une vue en perspective de la bride appartenant aux moyens selon l'invention illustré aux figures 4 et 5 pour la fixation du boîtier sur la paroi ;
[Fig. 7] - la figure 7 est une vue de détail en section par un plan vertical médian du de l'ensemble illustré aux figures 4 et 5 qui est représenté en état fixé de la bride sur la paroi ;
[Fig. 8] - la figure 8 est une vue en coupe par un plan vertical médian qui représente une étape intermédiaire du procédé d'installation du boîtier illustré notamment à la figure 4 ;
[Fig. 9] - la figure 9 est une vue en coupe par un plan vertical médian qui représente le boîtier à l'issue du procédé de fixation selon l'invention ;
Fig. 10A], [Fig. 10B], [Fig. 10C] - la figure 10A, la figure 10B et la figure 10C sont trois vues latérales permettant d'illustrer les principales étapes du procédé de fixation ;
[Fig. 11] - la figure 11 est une vue analogue à celle de la figure 3 qui illustre le logement du boîtier de la figure 2 équipé d'une bride a appartenant à un deuxième exemple de réalisation des moyens selon l'invention pour la fixation du boîtier sur une paroi verticale ;
[Fig. 12] - la figure 12 est une vue analogue à celle de la figure 11 selon un autre angle de vue ;
[Fig. 13] - la figure 13 est une vue latérale illustrant la coopération de la bride illustrée aux figures 11 et 12 avec une vis équipant la paroi de fixation ;
[Fig. 14] - la figure 14 est une vue en perspective des éléments représentés à la figure 13.

### Description détaillée des figures

Pour la description de l'invention et la compréhension des revendications, à titre non limitatif, on adoptera les orientations verticale, longitudinale et transversale selon le repère V, L, T indiqué aux figures dont les axes longitudinal L et transversal T s'étendent dans un plan horizontal. Par convention, l'axe longitudinal L s'étend d'arrière vers l'avant, tandis que l'axe transversal T s'étend de la gauche vers la droite.

Dans la description qui va suivre, des éléments identiques, similaires ou assurant des fonctions analogues seront désignés par les mêmes chiffres de référence.

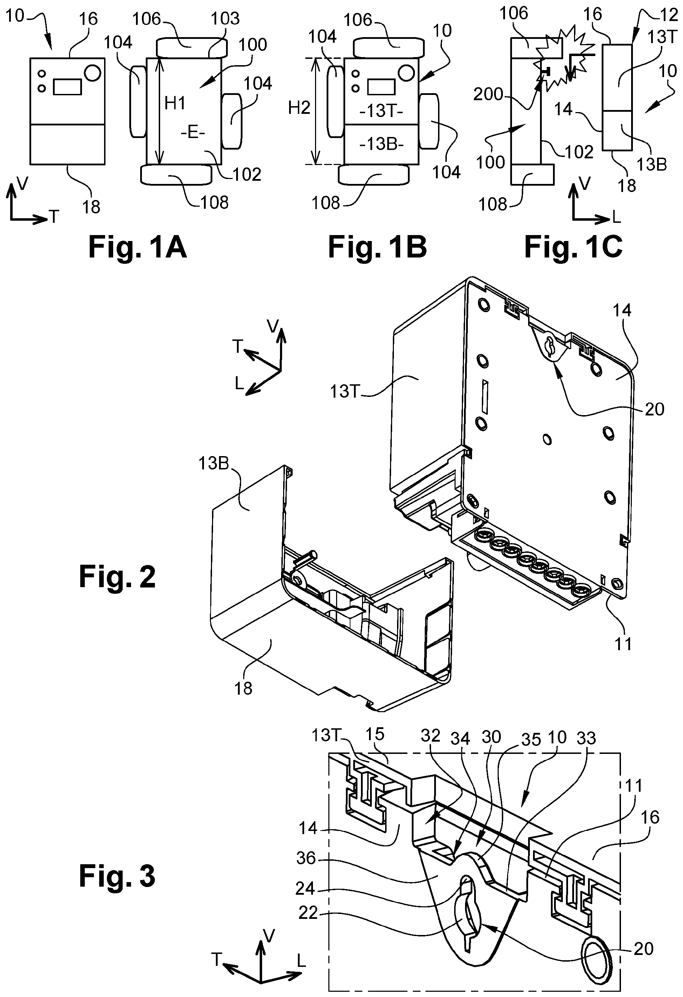

On a représenté aux figures, et notamment schématiquement aux figures 1A, 1B et 1C, une paroi verticale 100 qui est par exemple une plaque de fixation rapportée sur un mur, ou une cloison, (Non représenté).

La paroi 100 est délimitée longitudinalement vers l'avant par une face avant 102 d'orientation verticale sur laquelle on veut installer et fixer un compteur 10 - qui est ici un compteur électrique - qui doit pouvoir être logé dans un espace ou volume disponible « E » qui est de forme générale parallélépipédique rectangle et qui est délimité latéralement par des obstacles latéraux 104 transversalement opposés et, verticalement par des obstacles opposés supérieur 106 et inférieur 108 qui déterminent notamment une hauteur « H1 » de l'espace disponible E.

Le compteur 10 comporte un boîtier 12 qui est de forme générale parallélépipédique rectangle qui est délimité par une face arrière verticale plane 14 apte à être plaquée et maintenue en appui plan contre la face avant de la paroi verticale 102.

Le boîtier 12 est aussi délimité par une face supérieure 16 et par une face inférieure 18 globalement horizontales qui déterminent notamment une hauteur hors-tout « H2 » du boîtier 12.

Avec la face arrière 14, la face supérieure 16 délimite une arête arrière et supérieure 15 du boîtier d'orientation horizontale.

A titre d'exemple non limitatif, le boîtier 12 est ici constitué d'une plaque arrière 11 à laquelle appartient face arrière 14, une demi-coque avant supérieure 13T à laquelle appartient la face supérieure 16 et une demi-coque inférieure 13B - formant couvercle amovible - à laquelle appartient la face inférieure 18.

Pour pouvoir être contenue dans l'espace E, la hauteur H1 de l'espace E doit - a minima - être légèrement supérieure à la hauteur H2 du boîtier 12 du compteur 10.

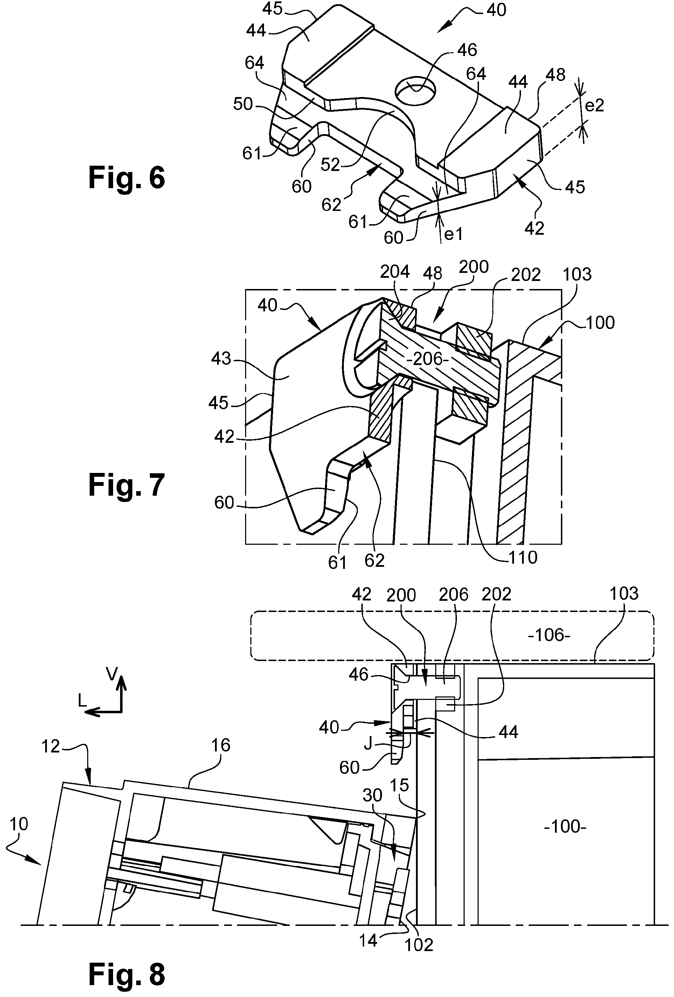

Comme il est connu de l'état de la technique, pour accrocher le compteur 10 sur la paroi 100, il est connu de fixer - à la partie supérieure de l'espace E et à proximité de son extrémité supérieure - une vis 200 qui est vissée sur la paroi 100 par exemple directement, mais plus couramment au moyen d'un écrou 202 reçu de manière réglable dans une rainure verticale 110 formée dans la face avant 102 de la paroi 100 (Voir notamment aux figures 3 et 6).

De manière connue, et comme on peut le voir notamment aux figures 2 et 3, à sa partie supérieure, la face arrière 14 du boîtier 12 comporte une boutonnière 20, aussi appelée lumière en « trou de clef », permettant l'introduction longitudinale de la tête 204 de la vis 200 dans sa partie la plus large 22, puis le déplacement vertical du boîtier 12 et de la boutonnière 20 vers le bas jusqu'à ce que la tige 206 de la vis 200 vienne en appui verticalement vers le haut contre l'extrémité supérieure 24 de plus faible largeur transversale de la boutonnière 20.

Comme illustré à la figure 1C, cette manipulation du compteur 10 nécessite donc de le positionner initialement verticalement par rapport à l'espace E à une altitude supérieure à sa position finale accrochée sur la paroi 100 correspondant à la position nominale d'installation du compteur.

Si les valeurs des hauteurs H1 et H2 sont sensiblement égales, on aboutit alors pratiquement à une impossibilité de réaliser l'accrochage du boîtier 12, qui est illustrée à la fifure 1C sur laquelle on voit que la partie supérieure de la face arrière 14 du boîtier 12 vient rencontrer l'obstacle supérieur 106.

Comme on peut le voir en détail aux figures 3, 8 et 9, dans sa partie supérieure arrière, le boîtier 12 comporte un logement 30 qui est centré transversalement.

Le logement 30 comporte :
- une partie supérieure 32 de contour sensiblement parallélépipédique rectangle et qui est ouverte verticalement vers le haut dans la face supérieure 16 et longitudinalement vers l'arrière dans la face arrière 14 ;
- et une partie inférieure 34 qui s'étend verticalement vers le bas à l'intérieur du boîtier 12 et qui est délimitée par une portion 36 de la face arrière 14 dans laquelle est agencée la boutonnière 20.

Dans la face arrière 14, les deux parties supérieure 32 et inférieure 34 du logement 30 sont délimitées par un bord supérieur horizontal 33 qui comporte un bossage central arrondi et convexe 35 orienté vers le haut.

### Premier exemple de réalisation de moyens de positionnement et de fixation pour la mise en œuvre du procédé selon l'invention

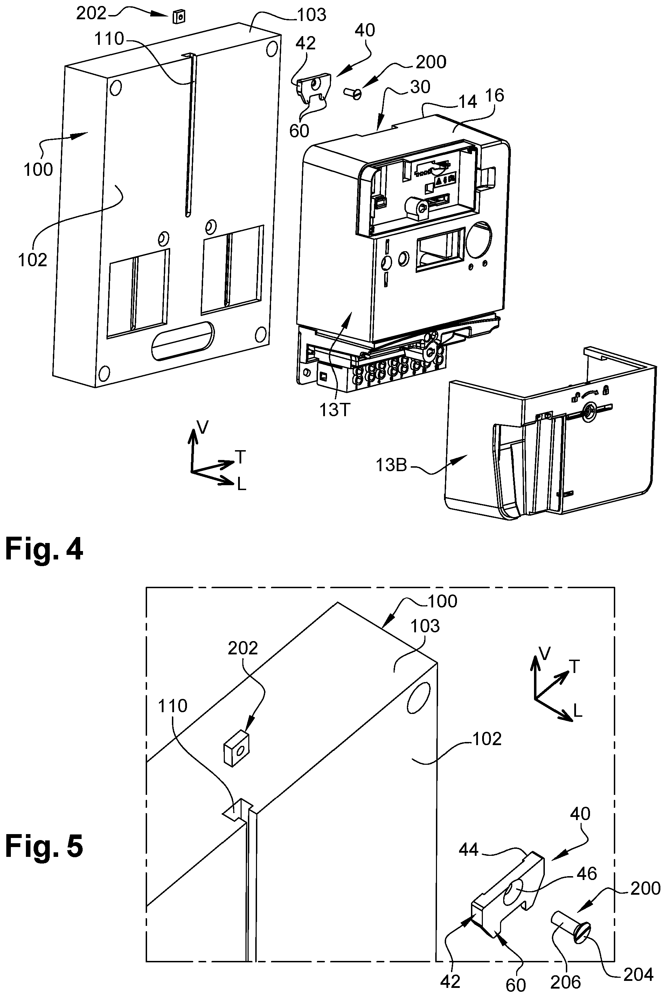

Comme on peut le voir notamment aux figures 4 à 9, pour son installation et sa fixation, le compteur 10, les moyens de fixation du compteur 10 comportent une bride d'installation 40 qui se présente sous la forme d'un composant associé au boîtier 12 dans le logement 30 duquel il est apte à être reçu pour participer au positionnement en partie haute du boîtier 12 et du compteur 10 le long de la paroi verticale 100.

Pour déterminer la position verticale du boîtier et maintenir la face arrière 14 du boîtier en appui plan contre la face avant 102 de la paroi verticale 100, la bride 40 comporte une embase supérieure 42 qui est apte à être fixée sur la paroi verticale 100 par la vis 200.

A cet effet, l'embase 42 comporte une face arrière plane en deux portions latérales 44 qui est fixée en appui plan sur une portion en vis-à-vis de la face avant 102 de la paroi verticale 100 et un trou débouchant 46 apte à être traversé par la tige filetée 206 de la vis 200 dont l'extrémité libre est reçue dans l'écrou de serrage 202.

L'embase 42 est délimitée par une face supérieure plane 48 qui, en position fixée de la bride 40 et comme on peut le voir aux figures 7 et 8, est coplanaire avec la face d'extrémité supérieure 103 de la plaque verticale.

L'embase 42 est encore délimitée par une face avant plane 43 et par deux faces latérales verticales 45 et elle est dimensionnée de manière à pouvoir être reçue avec jeu dans la partie supérieure 32 du logement 30.

Dans sa partie arrière, l'embase 42 est délimitée verticalement vers le bas par un bord horizontal inférieur 50 qui comporte un évidement central arrondi et concave 52 orienté vers le bas qui est complémentaire du bossage convexe 35.

L'embase 42 se prolonge verticalement par le bas par une patte 60 dont l'épaisseur « e1 » selon la direction longitudinale est inférieure d'une part à l'épaisseur longitudinale « e2 » de l'embase 42 et, d'autre part, à la dimension longitudinale de la partie inférieure 34 du logement 34 dans laquelle la patte 60 est apte à pénétrer verticalement pour y être logée.

La patte 60 est ici divisée en deux parties latérales espacées transversalement, comme les deux portions 44 de la face latérale arrière plane et qui délimitent entre elles un dégagement central 62.

La patte 60 en deux parties présente un profil incliné 61 en forme de rampe pour faciliter sa pénétration dans le logement et notamment dans sa partie inférieure 34.

Comme on peut le voir à la figure 8, lorsque la bride 40 est fixée sur la face avant 102 de la paroi verticale 100, il existe un jeu « J » selon la direction longitudinale entre la face arrière 64 de la patte 60 et la portion en vis-à-vis de la face avant 102 de la paroi latérale 100.

### Procédé d'installation du compteur grâce aux moyens de positionnement et de fixation selon le premier exemple de réalisation

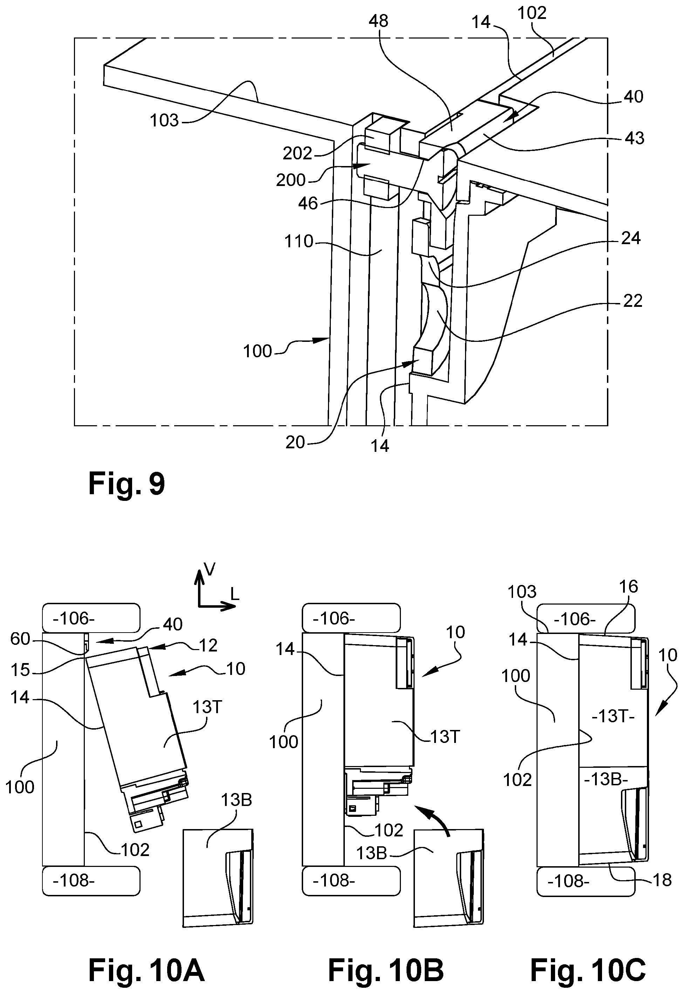

Le procédé selon l'invention est notamment illustré aux figures 10A à 10C.

Comme indiqué ci-dessus, après avoir ôté longitudinalement la demi-coque inférieure 13B une étape préalable E0) consiste à fixer la bride 40 sur la plaque verticale 100 dans la position illustrée notamment en détails aux figures 7 à 9.

Il est alors possible de procéder aux deux premières étapes successives E1) et E2) consistant d'abord à incliner la face arrière 14 du boîtier 12 par rapport à la paroi verticale 100 puis, ensuite, à amener l'arête supérieure arrière 15 du boîtier 12 adjacente à la face avant 102 de la paroi verticale 100.

Le boîtier 12 est alors dans la position illustrée à la figure 10A et en détail à la figure 8 dans laquelle la bride 40 - solidaire de la vis 200 - avec sa patte 60 est située au-dessus du boîtier 12 et en vis-à-vis du logement 30 qui est ouvert vers le haut.

L'étape suivante E3) consiste alors à déplacer verticalement le boîtier 12 vers le haut par rapport à la vis 200 - et donc par rapport à la bride 40 - jusqu'à une position haute d'installation du boîtier en faisant glisser l'arête 15 le long de la face avant 102 et en faisant simultanément pivoter le boîtier 12 par rapport à la paroi verticale 100 de manière à amener la face arrière 14 du boîtier en appui plan contre la face avant 102 de la paroi verticale 100.

Ce déplacement vertical et ce mouvement combiné de pivotement permettent d'atteindre la position nominale d'installation et l'orientation verticale du boîtier 12 telle que représentée aux figures 9 et 10B dans laquelle la face supérieure 16 du boîtier 12 est au contact de l'obstacle supérieur 106.

Ces manipulations et manœuvres du boîtier 12 avec pénétration de la patte 60 dans le logement 30 sont facilitées par le profil de rampe 61 de la patte 60 et le jeu « J » décrit plus haut.

En maintenant verticalement et longitudinalement le boîtier 12 dans la position illustrée à la figure 10A, au cours d'une étape suivante E4), le procédé consiste alors à immobiliser verticalement le boîtier 12 dans cette position haute d'installation par des moyens supplémentaires de fixation appartenant aux moyens de positionnement et de fixation, et par exemple au moyen d'au moins une vis supplémentaire de fixation (Non représentée aux figures) qui traverse axialement un trou du boîtier 12 et qui est vissée dans la paroi verticale 100).

Avantageusement, la partie inférieure du boîtier 12 sans sa la demi-coque inférieure 13B permet d'accéder à une ou plusieurs vis supplémentaires de fixation.

La ou les vis supplémentaire(s) de fixation permettent aussi - en partie basse du compteur 10 - de plaquer la face arrière 14 du boîtier 12 contre la face avant de la paroi 100 tandis que, en partie haute du compteur 10, c'est la patte 60 reçue dans le logement 30 qui maintient la face arrière 14 du boîtier 12 plaquée contre la face avant de la paroi 100.

Il est alors possible de remettre la demi-coque inférieure 13B en place et le compteur 10 avec son boîtier 12 est dans la position et l'état illustré à la figure 10C.

On remarque que la bride 40 est de conception extrêmement simple qui permet sa fabrication par différentes techniques peu coûteuses. Elle nécessite de devoir dans un premier temps être fixée avec précision sur la paroi verticale 100.

### Second exemple de réalisation de moyens de positionnement et de fixation pour la mise en œuvre du procédé selon l'invention

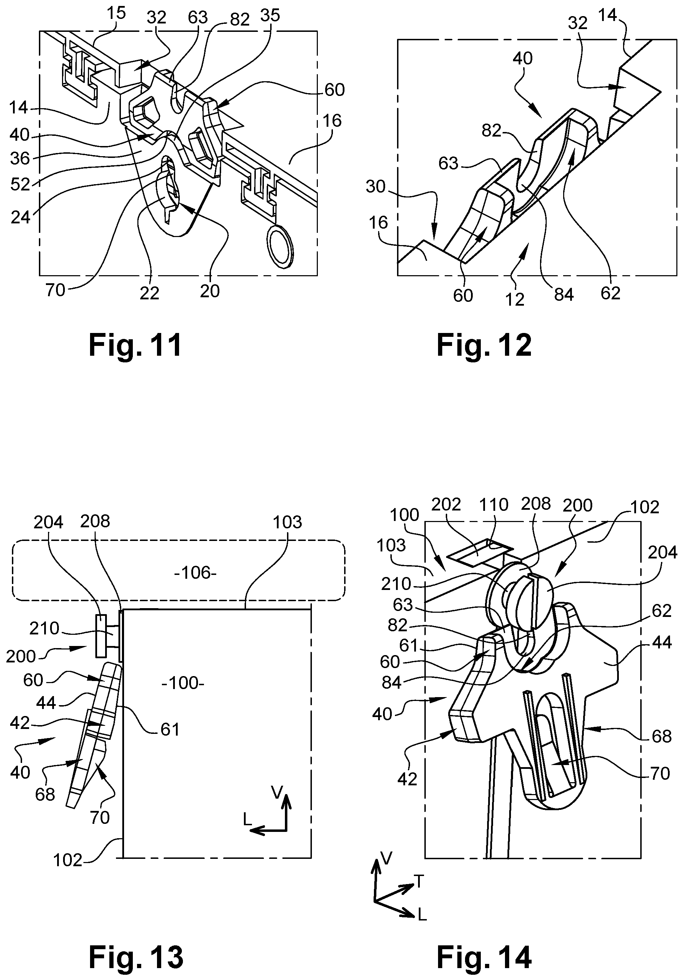

Comme on peut le voir aux figures 11 à 14, le boîtier 12 du compteur 10 est identique à celui qui a été décrit de manière détaillée dans le cadre du premier exemple ci-dessus.

Les moyens de fixation et de positionnement du boîtier 12 comportent à nouveau une vis 200 qui est fixée à la partie supérieure de l'espace E et à proximité de son extrémité supérieure au moyen d'un écrou 202 reçu de manière réglable dans une rainure verticale 110 formée dans la face avant 102 de la paroi 100 (Voir notamment les figures 13 et 14).

La vis 200 comporte ici un épaulement 208 qui est en appui serré contre la face avant 102 de la paroi verticale et qui délimite un tronçon 210 de la tige de la vis 200 qui s'étend longitudinalement vers l'avant à l'extérieur de la plaque verticale 100 et qui est délimité pat une tête plate 204 de la vis 200.

Le positionnement et la fixation de la vis 200 sont tels qu'elle occupe de préférence l'altitude la plus haute possible de l'épaulement 208 par rapport à la face supérieure 104 de la plaque verticale 100 (Voir figure 13).

Comme précédemment, les moyens de fixation et de positionnement du boîtier 12 comportent à nouveau une bride d'installation 40.

Pour positionner et fixer la bride 40 dans le logement 30 du boîtier 12, la bride 40 comporte une embase 42, qui est ici inférieure en considérant les figures 11 à 14 et qui est apte à être logée dans le logement 30 et à y être fixée par emboîtement élastique.

L'embase 42 comporte une face arrière plane 44 qui, en position fixée de la bride 40 dans le logement 30 est coplanaire à la face arrière 14 du boîtier 12.

Pour sa fixation et sa retenue dans le logement 30, l'embase 42 se prolonge verticalement vers le bas par un prolongement inférieur 68 qui porte une languette déformable élastiquement qui est apte à être reçue dans l'extrémité supérieure 24 de plus faible largeur transversale de la boutonnière 20 (Voir figure 11).

L'embase 42 se prolonge verticalement par le haut par une patte 60. La patte 60 est divisée en deux parties latérales espacées transversalement délimitent entre elles un dégagement central 62 qui délimite une portion centrale 63 d'épaisseur réduite de la patte 60.

Comme on peut le voir à la figure 13, la patte 60 présente un profil aminci qui résulte de l'inclinaison de sa face arrière 61 par rapport au plan de sa face arrière plane 44 qui est coplanaire à la face arrière 14 du boîtier 12.

Dans sa portion centrale 63 d'épaisseur réduite, la patte 60 comporte une fente 82 d'orientation verticale qui est ouverte vers le haut et qui est délimitée verticalement vers le bas par un fond 84 concave qui est apte à coopérer avec le tronçon 210 de la vis 200, tandis que le dégagement central 62 est dimensionné pour loger la tête 204 de la vis 200.

Le tronçon d'extrémité libre supérieure de la patte 60 est conformé et profilé en forme de rampe pour faciliter la pénétration de la tige de la vis 200 dans la fente 82 lorsque, au cours de son déplacement vers haut, la face arrière (14) du boîtier (12) 12, équipé de la bride 40, est inclinée par rapport à la paroi verticale.

### Procédé d'installation du compteur grâce aux moyens de positionnement et de fixation selon le second exemple de réalisation

Le procédé selon l'invention est notamment illustré partiellement aux figures 13 et 14.

Comme indiqué ci-dessus, après avoir ôté longitudinalement la demi-coque inférieure 13B une étape préalable E0) consiste à fixer la bride 40 sur le boîtier 12 dans le logement 30 en l'y emboîtant élastiquement en fixant ainsi la patte 60 sur le boîtier 12 selon une position et une orientation verticale permettant à la vis 200 de pénétrer dans la fente 82 de la patte 60.

La bride 40 est alors dans la position représentée aux figures 11 et 12.

Il est alors possible de procéder aux deux premières étapes successives E1) et E2) consistant d'abord à incliner la face arrière 14 du boîtier 12 et de la bride 40 par rapport à la paroi verticale 100 puis ensuite à amener l'arête supérieure arrière 15 du boîtier 12 adjacente à la face avant 102 de la paroi verticale 100.

Le boîtier 12 est alors dans la position illustrée aux figures 13 et 14 dans laquelle la bride 40 - solidaire du boîtier 12 - avec sa patte 60 est située au-dessous de la vis 200 avec la fente 82 ouverte vers le haut qui est centrée transversalement et alignée avec le tronçon 210 de la vis 200.

L'étape suivante E3) consiste alors à déplacer verticalement le boîtier 12 avec la bride 40 vers le haut par rapport à la vis 200 jusqu'à une position haute d'installation du boîtier en faisant glisser l'arête 15 le long de la face avant 102 et en faisant simultanément pivoter le boîtier 12 par rapport à la paroi verticale 100 de manière à amener la face arrière 14 du boîtier en appui plan contre la face avant 102 de la paroi verticale 100.

Ce déplacement vertical et mouvement de pivotement permettent d'atteindre la position nominale d'installation et l'orientation verticale du boîtier 12 dans laquelle la face supérieure 16 du boîtier 12 est au contact de l'obstacle supérieur 106.

Ces manipulations et manoeuvres du boîtier 12 avec pénétration du tronçon 210 de la vis 200 dans la fente 82 sont facilitées par le profil en coin de la patte 60.

En maintenant verticalement et longitudinalement le boîtier 12 dans la position atteinte à l'issue de l'étape précédente E3), au cours d'une étape suivante E4), le procédé consiste alors à immobiliser verticalement le boîtier 12 dans cette position haute d'installation par des moyens supplémentaires de fixation appartenant aux moyens de positionnement et de fixation, et par exemple au moyen d'au moins une vis supplémentaire de fixation (Non représentée aux figures) qui traverse axialement un trou du boîtier 12 et qui est vissée dans la paroi verticale 100).

Avantageusement, la partie inférieure du boîtier 12 sans sa la demi-coque inférieure 13B permet d'accéder à une ou plusieurs vis supplémentaires de fixation.

La ou les vis supplémentaire(s) de fixation permettent aussi - en partie basse du compteur 10 - de plaquer la face arrière 14 du boîtier 12 contre la face avant de la paroi 100 tandis que, en partie haute, c'est la patte 60 - en coopération avec la vis 200 - qui maintient la face arrière 14 du boîtier 12 plaquée contre la face avant 102 de la paroi 100.

Il est alors possible de remettre la demi-coque inférieure 13B en place et le compteur 10 avec son boîtier 12 est dans une position et un état analogue illustré à la figure 10C.

Comme cela vient d'être décrit de manière détaillée, la conception du boîtier 12 avec son logement 30 avec l'une ou l'autre des deux conceptions des moyens de positionnement et de fixation permet de mettre en œuvre le procédé d'installation selon l'invention qui permet d'installer le compteur 10 dans un environnement dimensionnel.

La conception de la bride est plus complexe que dans le premier exemple de réalisation, mais elle permet à l'installateur de la fixer dans un premier temps de manière fiable sur le boîtier, tandis que la fixation de la vis sur la paroi verticale est simplifiée.

## Revendications

1. Procédé d'installation sur une paroi verticale (100) d'un boîtier (12) d'un compteur (10) d'énergie qui est délimité :
- par une face arrière (14) apte à être maintenue en appui plan contre une face avant (102) de la paroi verticale (102) ;
- et par une face supérieure (16) destinée à occuper une position verticale déterminée le long de la paroi verticale (100) et qui, avec la face arrière (14) du boîtier (12), détermine une arête supérieure arrière (15) du boîtier (12),
par des moyens de positionnement et de fixation qui comportent, au niveau de la face supérieure (16) du boîtier (12), une vis (200) fixée sur la paroi verticale (100) et une patte (60) qui, lors de l'installation du boîtier (14) sur la face avant (102) de la paroi verticale (100), coopèrent pour maintenir la face arrière (14) du boîtier en appui plan contre la face avant (102) de la paroi verticale (100),
procédé qui comporte les étapes successives consistant à :
-- E1) incliner la face arrière (14) du boîtier (12) par rapport à la paroi verticale (100) ;
-- E2) amener l'arête supérieure arrière (15) du boîtier adjacente à la face avant (102) de la paroi verticale (100) ;
-- E3) déplacer le boîtier (12) vers le haut par rapport à la vis (200) jusqu'à une position haute d'installation du boîtier (12) en faisant simultanément pivoter le boîtier (12) par rapport à la paroi verticale (100) de manière à amener la face arrière (14) du boîtier (12) en appui plan contre la paroi verticale (100) ;
-- E4) immobiliser verticalement le boîtier (12) dans sa position haute d'installation par des moyens supplémentaires de fixation appartenant auxdits moyens de positionnement et de fixation.

2. Procédé selon la revendication 1, **caractérisé en ce qu'**il comporte une étape préalable E0) consistant, au moyen de la vis (200), à fixer ladite patte (60) sur la face avant (102) de la paroi verticale (100) selon une position et une orientation lui permettant de pénétrer dans un logement complémentaire (30) du boîtier (12).

3. Procédé selon la revendication 1, **caractérisé en ce qu'**il comporte une étape préalable E0) consistant à fixer la patte (60) sur le boîtier (12) selon une position et une orientation permettant à la vis (200) de pénétrer dans une fente (82) de la patte (60).

4. Procédé selon la revendication 1, **caractérisé en ce que**, pour immobiliser verticalement le boîtier (12) dans sa position haute d'installation, lesdits moyens supplémentaires de fixation comportent au moins une autre vis qui traverse axialement un trou du boîtier (12) et qui est vissée dans la paroi verticale (100).

5. Compteur (10) d'énergie pour la mise en œuvre du procédé d'installation selon la revendication 3, qui comporte un boîtier (12) :
- qui est délimité par une face arrière (14) apte à être maintenue en appui plan contre une face avant (102) d'une paroi verticale (100) et par une face supérieure qui est destinée à occuper une position verticale déterminée le long de la paroi verticale (100) et qui, avec la face arrière (14) du boîtier (12), détermine une arête supérieure arrière (15) du boîtier (12) ;
- qui comporte un logement (30) qui est ouvert dans sa face supérieure, compteur (10) qui porte une bride (40) d'installation dont une patte (60), comportant une fente (82), qui est apte à être fixée par une vis (200) sur la paroi verticale (100), qui détermine la position verticale du boîtier (12) et qui maintient la face arrière (14) du boîtier (12) en appui plan contre la face avant (102) de la paroi verticale (100),
compteur (10) dans lequel :
-- la bride (40) d'installation comporte une embase (42) pour sa fixation dans ledit logement (30) ;
-- la patte (60) prolonge l'embase (42) vers le haut ;
-- la fente (82) est ouverte vers le haut pour, lorsque le boîtier (12) est déplacé vers le haut par rapport à la vis (200), permettre à la vis (200) de pénétrer verticalement dans la fente (82).

6. Compteur (10) d'énergie selon la revendication précédente, **caractérisé en ce qu'**un tronçon d'extrémité libre supérieure de la patte (60) est profilé en forme de rampe pour faciliter la pénétration de la vis (200) dans la fente (82) lorsque, au cours de son déplacement vers haut, la face arrière (14) du boîtier (12) est inclinée par rapport à la paroi verticale (100).

7. Compteur (10) d'énergie selon l'une des revendications 5 ou 6, **caractérisé en ce que** l'embase (42) est fixée dans ledit logement (30) par emboîtement élastique.

8. Bride (40) pour l'installation sur une paroi verticale (100) d'un compteur (10) d'énergie par la mise en œuvre du procédé de la revendication 2, **caractérisée en ce que** :
- elle comporte une embase (42) apte à être fixée sur la paroi verticale (100) par une vis (200) et qui se prolonge, verticalement vers le bas, par une patte (60) ;
- l'embase (42) comporte une face arrière plane (44) apte à être montée serrée, en appui plan sur la face avant (102) de la paroi verticale (100), par la vis (200) qui traverse axialement un trou de l'embase (42) orthogonal au plan de sa face arrière (44) ;
- la patte (60) est décalée axialement vers l'avant par rapport au plan de la face arrière (44) de l'embase (42), de manière à délimiter un jeu (J) par rapport à la face avant (102) de la paroi verticale (100).

9. Bride (40) selon la revendication précédente, **caractérisée en ce que** l'extrémité libre inférieure de la patte (60) est profilée en forme de rampe pour faciliter sa pénétration dans le logement (30) lorsque, au cours du déplacement du boîtier (12) vers haut, la face arrière (14) du boîtier (12) est inclinée par rapport à la paroi verticale (100).

10. Bride (40) pour l'installation sur une paroi verticale (100) d'un compteur (10) d'énergie par la mise en œuvre du procédé de la revendication 3, **caractérisée en ce qu'**elle comporte une embase (42), apte à être fixée dans un logement (30) du boîtier (12) du compteur, qui se prolonge verticalement vers le haut par une patte (60) comportant une fente (82) qui est ouverte vers le haut pour permettre à une vis (200) de pénétrer verticalement dans la fente (82).

11. Bride (40) d'installation selon la revendication précédente, **caractérisée en ce que** l'embase (42) est apte à être fixée par emboîtement élastique dans ledit logement (30) du boîtier (12) du compteur.
